**Europäisches Patentamt**

**European Patent Office**

**Office européen des brevets**

(19)

(11) Veröffentlichungsnummer: **0 174 537**
**A1**

(12) **EUROPÄISCHE PATENTANMELDUNG**

(21) Anmeldenummer: 85110582.5

(22) Anmeldetag: 22.08.85

(51) Int. Cl.⁴: **H 01 L 23/46**
**H 01 L 23/42**

(30) Priorität: 10.09.84 DE 3433165

(43) Veröffentlichungstag der Anmeldung:
19.03.86 Patentblatt 86/12

(84) Benannte Vertragsstaaten:
AT BE CH DE FR GB IT LI LU NL SE

(71) Anmelder: **Siemens Aktiengesellschaft**
**Berlin und München Wittelsbacherplatz 2**
**D-8000 München 2(DE)**

(72) Erfinder: **Prussas, Herbert, Dipl.-Ing.**
**Mozartring 11**
**D-8069 Reichertshausen(DE)**

(54) Im Betrieb von einem Kühlmedium umströmter federnder Kühlkörper.

(57) Im Betrieb von einem Kühlmedium, z.B. Kühlluft, umströmter federnder Kühlkörper (4, 4a, 5, 5a, 6, 7, 7a) mit einer Auflagefläche (3) zur Bedeckung von Oberflächenteilen eines Abwärmekörpers (1), welcher zumindest zeitweise Verlustwärme abgibt, und mit einer oder mehreren wärmeleitenden – z.B. stabförmigen oder bandförmigen – im Betrieb vom Kühlmedium umspülten Kühlfahnen (4, 4a, 5, 5a, 6, 7, 7a). Mindestens zwei Auflageflächen (3) sind weitgehend parallel einander gegenüber liegend im Spalt zwischen zwei Abwärmekörpern (1) unter Druckspannung einfügbar, wobei zwischen diesen Auflageflächen (3) mindestens eine federnde gemeinsame Kühlfahne (4) 4a, 5, 5a, 6, 7, 7a) liegt, welche über die Auflageflächen (3) Federkräfte auf die Oberflächenteile dieser Abwärmekörper (1) ausübt, sobald der Kühlkörper zwischen diese Abwärmekörper (1) eingefügt ist.

FIG 1

EP 0 174 537 A1

0174537

SIEMENS AKTIENGESELLSCHAFT     Unser Zeichen:

Berlin und München     VPA 84 P 1 6 7 5 E

**Im Betrieb von einem Kühlmedium umströmter**

**federnder Kühlkörper**

Die Erfindung betrifft eine Verbesserung des im Oberbegriff genannten speziellen Kühlkörpers, der dem Halbleiterfachmann durch GB 1 455 002 und durch das Prospekt der Fa. redpoint "Catalogue Addendum Jan. 84 Additional Heatsink Patterns" bekannt ist.

Die Erfindung wurde an sich zunächst für einen speziellen Abwärmekörper mit Halbleitern, nämlich für ein spezielles 200 MBit/sec-Modul mit Glasfaseranschluß für die Umsetzung von elektrischen in optische Signale entwickelt. Dieses Modul enthält u.a. einen nahe seiner höchstzulässigen Betriebstemperatur, nämlich bei etwa 125°C betriebenen Treiber mit etwa 1 W Verlustleistung, wobei mit Kühlluft als Kühlmedium von etwa 40°C und 100 m/sec geblasen wird. Die Gehäuse der Module werden in hoher Vielzahl nebeneinander sehr dicht gepackt auf Leiterplatten als gemeinsamem Träger untergebracht. Die Einbauplatzverhältnisse sind extrem eng, wobei Abstände zwischen den benachbarten Modulen eines Trägers, und vom Modul zur darüberliegenden Decke die den nächsten Träger für weitere Module bildet, z.B. nur 5 mm betragen. Ohne ganz besondere Kühlmaßnahmen werden die Gehäuse und damit die Treiber zu heiß und sind dann nicht betriebsfähig, vgl. auch die älteren Anmeldungen P 34 29 234.9, P 34 29 269.1 und P 34 29 281.0.

Die Erfindung eignet sich jedoch nicht nur für jenes Modul, sondern weit darüberhinaus für alle durch den Oberbegriff des Patentanspruches 1 definierten Abwärmekörper, z.B. für Gehäuse von elektronischen Bauteilen wie Halbleitern.

Be 1 Ky/30.08.1984

Die Aufgabe der Erfindung ist, den Wärmeübergangswiderstand zwischen dem Abwärmekörper/Gehäuse und dem Kühlmedium mit einfachsten Mitteln stark zu verringern, - bei
Bedarf sogar nachträglich in bereits fertig montierten Anordnungen so zu verringern,daß selbst bei äußerst beengten Einbauverhältnissen und mäßig günstigen Kühlmediumdaten die höchstzulässigen Betriebstemperaturen des Abwärmekörpers,z.B. Halbleiterkörpers,noch eingehalten
werden können. Dazu soll auf einfach handhabbare Weise
der ganze Spalt zwischen zwei Abwärmekörpern,bzw. zwischen dem Abwärmekörper und einem beliebigen anderen Körper, mit einer oder mehreren Kühlfahnen weitgehend bzw.
voll ausfüllbar sein, und zwar trotz hoher Toleranzen
der jeweiligen Spaltbreite mit ein und demselben Kühlkörper. Diese Aufgabe wird durch die im Patentanspruch 1
angegebenen Maßnahmen gelöst.

Zusätzlich gestatten die Maßnahmen nach Patentanspruch

2, den Wärmeübergangswiderstand zwischen dem Abwärmekörper
und der/den Kühlfahne(n) zu verringern,

3, alleine schon durch den eigenen Federdruck der Zungen
auf den Abwärmekörper, den Wärmeübergangswiderstand
zwischen dem Abwärmekörper und der/den Kühlfahne(n)
weiter zu verringern,

4, die Kühlfahne leicht herstellen zu können,

5, die Kühlfahne besonders leicht herstellen zu können,

6, die Kühlfahne(n) und ihr Auflageblech besonders leicht
herstellen zu können,

7, eine besonders große Oberfläche der Kühlfahnen, bezogen auf ihr Gewicht, zu erreichen,

8, bei besonders großer Oberfläche der Kühlfahnen, bezogen auf ihr Gewicht, eine besonders einfache Herstellung des Kühlkörpers, z.B. mittels einer Schere aus
einer großen Filzplatte, zu erreichen,

9, eine besonders hohe innere Wärmeleitfähigkeit des
Kühlkörpers und damit einen besonders geringen Wärmeübergangswiderstand zwischen dem Abwärmekörper und dem
Kühlmedium zu erreichen,

10, eine nachträgliche Anbringung der besonders wirksamen leicht herstellbaren Kühlfahne(n) in einer im übrigen fertigen Anordnung, z.B. auf elektronischen Leiterplatten als gemeinsamem Träger, mit besonders geringem Aufwand zu ermöglichen,

11, eine nachträgliche Anbringung der besonsers wirksamen leicht herstellbaren Kühlfahne(n) in einer im übrigen fertigen Anordnung, z.B. in einem Stapel mehrerer Leiterplatten als Träger von eigenen Abwärmekörpern, mit besonders wenig Aufwand zu ermöglichen,

12, ein Verrutschen des Kühlkörpers, selbst bei Durchblasen mit einem kräftigen Kühlluftstrom mittels kräftigem Gebläse, zu verhindern, sowie

13, die Wärmeableitung in einem besonders kritischen Fall elegant, nämlich nachträglich mit besonders wenig Aufwand hochwirksam zu ermöglichen.

Die Erfindung wird anhand der in den Figuren gezeigten Ausführungsbeispiele weiter erläutert, wobei die Figur

1 in Seitenansicht mehrere direkt nebeneinander und übereinander auf zwei Trägern unter sehr engen Einbauverhältnissen angebrachte, nachträglich auf verschiedene Weise erfindungsgemäß behandelte Abwärmekörper,

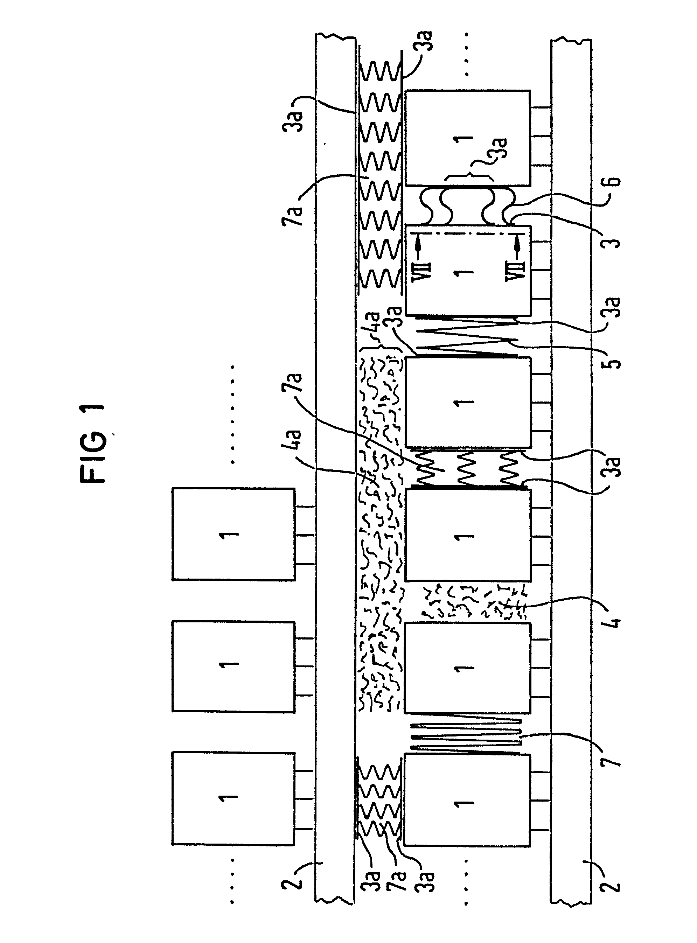

2 in Draufsicht einen Teil der in Fig. 1 gezeigten Abwärmekörper,

3 eine besondere Kühlkörpervariante,

4 ein Zwischenprodukt zur Herstellung einer weiteren Kühlkörpervariante,

5 eine andere Kühlkörpervariante,

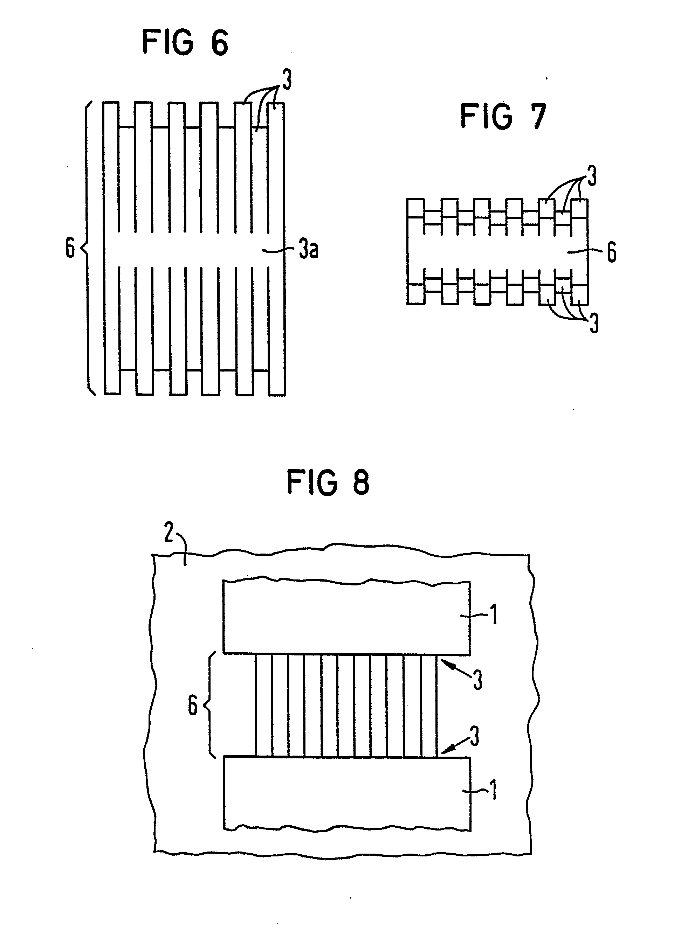

6 ein Zwischenprodukt zur Herstellung einer noch anderen, in Fig. 7 im Fertigzustand gezeigten Kühlkörpervariante,

8 in Draufsicht die in Fig. 7 gezeigte Kühlkörpervariante nach ihrer Anwendung bei dem in Fig. 1 in Seitenansicht gezeigten Beispiel,

0174537

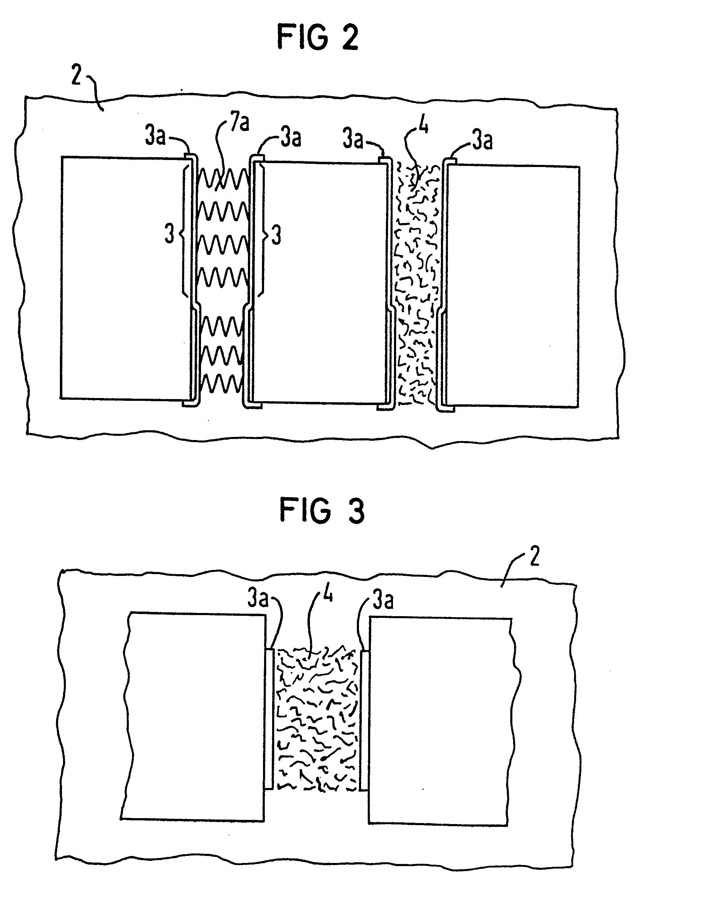

9 in Draufsicht eine zusätzliche Variante einer der in Fig. 2 gezeigten Kühlkörpervarianten, und

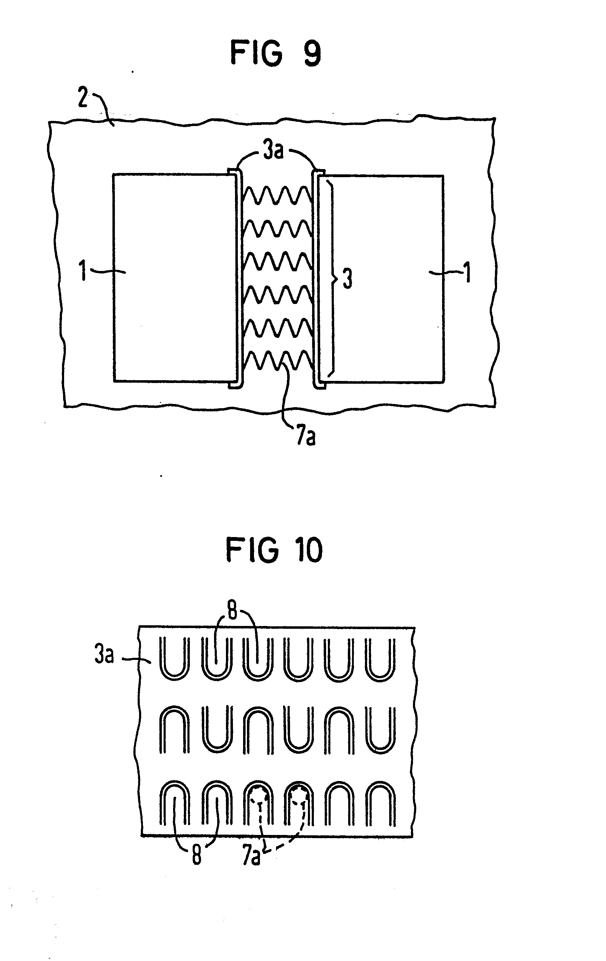

10 eine weitere günstige Variante von in den Fig. 2 und 9 gezeigten Kühlkörpervarianten zeigen.

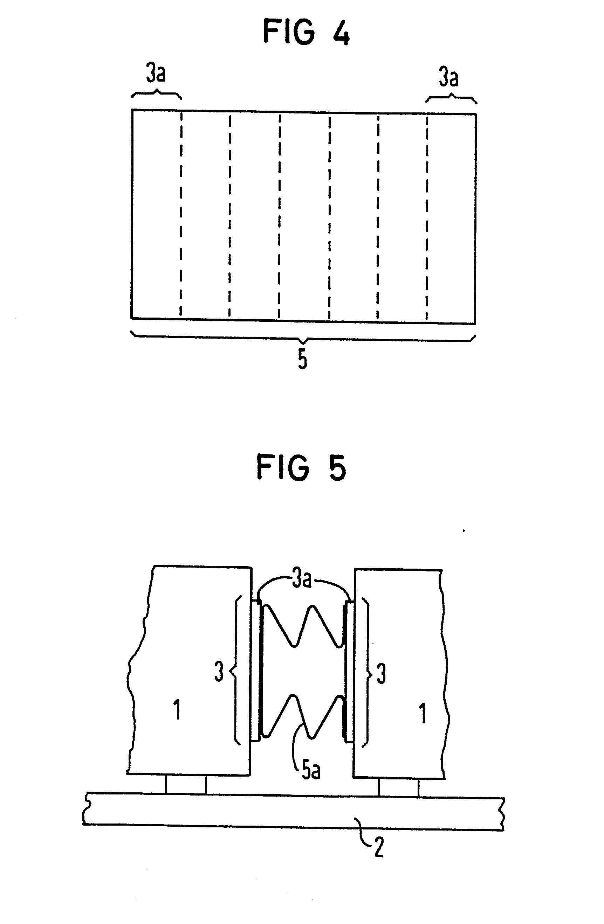

Bei allen diesen Figuren handelt es sich um erfindungsgemäße Beispiele. Die Kühlkörper werden im Betrieb z.B. mit einem Gebläse beblasen,was Kühlluft durch die Kühlfahnen 4 bzw. 4a, 5 bzw. 5a, 6 und 7 bzw. 7a dieser Kühlkörper bläst, wobei die Kühlfahnen für sich an sich weitgehend beliebige, in Fig. 1 beispielhaft gezeigte Formen aufweisen können, nämlich z.B. Spiralfedern 7 bzw. 7a - vgl. auch Fig. 2 und 9, oder Filz 4 bzw. 4a - vgl. auch Fig. 2 und 3, ferner z.B. gefaltete oder sonstwie gebogene Folien 5 bzw. 5a  - vgl. auch Fig. 5 und 7. Wesentlich ist dabei vor allem, daß diese Kühlfahnen jeweils einerseits in sich nicht nur wärmeleitend, sondern auch federnd sind und jeweils zwischen mindestens zwei Auflageflächen 3 angebracht sind, welche ihrerseits,weitgehend parallel einander gegenüber liegend,im Spalt zwischen zwei Abwärmekörpern 1 unter Druckspannung einfügbar sind. Zwischen diesen Auflageflächen 3  liegt demnach mindestens eine federnde Kühlfahne,welche den beiden Auflageflächen 3 gemeinsam ist und welche über diese Auflageflächen 3 Federkräfte auf die Oberflächenteile dieser Abwärmekörper 1 ausübt, sobald der Kühlkörper zwischen  diese Abwärmekörper 1 eingefügt ist, vgl. Fig. 1.

Bei den in den Figuren gezeigten Abwärmekörpern 1 handelt es sich z.B. um spezielle Gehäuse von Abwärmekörpern mit Halbleitern, z.B. mit einem bei etwa 125°C betriebenen Treiberchip mit etwa 1 W Verlustleistung, wobei Kühlluft als Kühlmedium von etwa 40°C und 100 m/sec verwendet wird. Die Gehäuse 1 werden in hoher Vielzahl nebeneinander sehr dicht gepackt auf Leiterplatten 2 als gemeinsamem Träger 2 untergebracht und mehrere solche Leiterplatten 2 übereinander angeordnet, vgl. Fig. 1. Die Einbauverhältnisse sind also extrem eng, wobei die Abstände zwischen den benachbarten Gehäusen 1 eines Trägers, und vom Gehäuse 1 zur darüberliegenden Leiterplatte 2, z.B. nur 5 mm betragen.

Die Erfindung ermöglicht, den Wärmeübergangswiderstand zwischen dem jeweiligen Gehäuse 1 und dem Kühlmedium mit einfachsten Mitteln sogar nachträglich mit sehr wenig Aufwand in der bereits fertig montierten elektronischen Schaltung so zu verringern, daß selbst bei diesen äußerst beengten Einbauverhältnissen und mäßig günstigen Kühlmediumdaten die höchstzulässigen Betriebstemperaturen des verlustwärmeabgehenden Halbleiterkörpers im Gehäuse 1 noch eingehalten werden können, vor allem indem - sogar nachträglich - in die Spalte der elektronischen Anordnung, vor allem in die Spalte zwischen zwei Verlustwärme-abgebenden Gehäusen/Abwärmekörpern 1, noch die erfindungsgemäßen elastischen/federnden Kühlkörper 4/4a, 5/5a, 6, 7/7a eingefügt werden. Auch in die Spalte zwischen einem Abwärmekörper 1 und einem kaum oder nicht Verlustwärme abgebenden weiteren Körper, vgl. die Leiterplatte 2 in Fig. 1, kann der erfindungsgemäße Kühlkörper unter Druckspannung - sogar ebenfalls nachträglich in eine schon fertig montierte Anordnung - eingefügt werden, vgl. die Kühlkörper mit den Kühlfahnen 3a, 4a, 7a in Fig. 1 zwischen den unteren Kühlkörpern 1 und der oberen Leiterplatte 2.

Hierbei kann der erfindungsgemäße Kühlkörper auch sehr große Auflageflächen aufweisen, wodurch die eine seiner Kühlflächen gleich mehrere Abwärmekörper 1 gemeinsam abdecken und damit gemeinsam kühlen kann, vgl. z.B. wieder die Kühlkörper mit den Kühlfahnen 4a und 7a in Fig. 1. Die kombinierte Anwendung von erfindungsgemäßen Kühlkörpern sowohl jeweils zwischen zwei Abwärmekörpern 1 als auch zwischen einem Abwärmekörper 1 und abwärmearme Körper 2, vgl. Fig. 1, stellt eine besonders gut wirksame - auch nachträglich durchführbare - Kühlungsmaßnahme dar, die mit einfachsten Mitteln rasch erreicht werden kann.

Der Wärmeübergang zwischen dem Abwärmekörper 1 und der gemeinsamen federnden Kühlfahne, bzw. und den gemeinsamen federnden Kühlfahnen können weiter verringert werden, indem die Auflagefläche 3 jeweils durch eine Oberfläche eines Auflagebleches 3a gebildet wird, vgl. Fig. 1 mit Fig. 3, 5 und 9, wobei sich an den Auflageblechen 3a die federnde(n) gemeinsame(n) Kühlfahne(n) 4 (Fig. 2, 3), 5a (Fig. 1, 5) und 7/7a (Fig. 1, 2, 9) abstützen.

Besonders leicht herstellbar, bei guter Kühlwirkung und besonders hoher Elastizität  also bei besonders großer Toleranz der Breite des für den betreffenden Kühlkörper geeigneten Spaltes, ist ein Kühlkörper, bei dem die gemeinsame Kühlfahne 7 bzw. 7a jeweils eine Spiralfeder bildet, wobei der betreffende Kühlkörper gleichzeitig sogar eine hohe Vielzahl solcher gemeinsamen Spiralfedern aufweisen kann, vgl. 7a in Fig. 1, 2, 9. Solche Kühlkörper mit einer oder mit mehreren Spiralfedern 7, 7a kühlen besonders gut, wenn ihre Auflagebleche 3a an möglichst vielen Punkten jeweils kräftig auf die darunterliegenden Oberflächenteile des Abwärmekörpers 1 drücken - wenn dazu nämlich in die Auflagebleche 3a

jeweils eine oder mehrere, für sich federnde Zungen 8 eingestanzt sind, wobei sich einzeln jede der verschiedenen, eine Kühlfahne bildenden Spiralfedern 7, 7a jeweils an einer solcher Zunge 8 abstützt, vgl. Fig. 10 mit Fig. 1, 2, 9.

Besonders leicht sind auch solche Kühlkörper herzustellen, bei denen die gemeinsame Kühlfahne einen einfach - meistens aber mehrfach - gefalteten Federblechstreifen 5 bildet, vgl. Fig. 1, 5, wobei im allgemeinen zwei oder noch mehr Streifenabschnitte 3a des Federblechstreifens zugleich als Auflagebleche 3a dienen. Fig. 4 zeigt ein Beispiel eines solchen Federblechstreifens 5 vor seiner Faltung.

Eine besonders große Oberfläche bei starker Durchwirbelung des Kühlmediums und damit eine besonders gute Kühlwirkung hat ein Kühlkörper, dessen gemeinsame Kühlfahne eine elastische Filzstruktur 4 aus sehr gut wärmeleitendem Material aufweist, vgl. Fig. 1, 2, 3. Dieser Kühlkörper 4 kann, z.B. angelötete, Auflagebleche 3a aufweisen, vgl. Fig. 2, 3, und insgesamt z.B. aus Kupfer, also vor allem aus Kupferfasern mit Filzstruktur, bestehen. Besonders leicht handhabbar ist aber dieser Kühlkörper 4 mit Filzstruktur, wenn er auflageblechfreie Auflageflächen 3 aufweist, vgl. Fig. 1. Man kann einen solchen Kühlkörper 4 dann sogar mit einer Schere aus einer großen Filzmatte maßgerecht bzw. dem Bedarf entsprechend herausschneiden und in die Anordnung einlegen. Metallische Kühlkörper können auch die Abschirmung/Erdung verbessern. - Die gemeinsame(n) Kühlfahne(n) kühlt/kühlen umso besser, je höher die innere Wärmeleitfähigkeit einer solchen Kühlfahne ist. Bevorzugt besteht daher auch die Kühlfahne bzw. der ganze Kühlkörper aus Metall, besonders wenn er eine Filzstruktur aufweist.

Der Kühlkörper kühlt nicht nur dann gut, wenn er unter Druckspannung in den Spalt zwischen zwei Abwärmekörper 1 eingefügt ist - er kühlt dann beide Abwärmekörper 1, vgl. Fig. 1, 2, 3, 5, 8, 9. Er kühlt aber den betreffenden Abwärmekörper 1 auch schon dann gut, wenn dieser Kühlkörper 4, 4a, 5, 5a, 6, 7, 7a jeweils nur zwischen dem Abwärmekörper 1 und einem kaum oder nicht Verlustwärme abgebenden weiteren Körper 2 unter Druckspannung eingefügt ist, vgl. dazu Fig. 1. Mit dem erfindungsgemäßen Kühlkörper kann man also alle Spalten rund um einen Abwärmekörper 1 zur Verbesserung der Wärmeableitung ausstatten.

Selbst bei hohen Kühlmediumgeschwindigkeiten wird das Verrutschen des Kühlkörpers dadurch verhinderbar, daß seine Auflageflächen 3 jeweils, z.B. mittels Klebstoff, an den gedrückten Oberflächenteilen 1, 2 dauerhaft befestigt werden, und/oder seine Auflagebleche 3a zur Lagefixierung eine oder mehrere Abwinkelungen zum Umgreifen *) Wie bereits erwähnt, ist die Erfindung besonders bei elektronischen Anordnungen vorteilhaft anwendbar, nämlich besonders, wenn der Abwärmekörper 1 jeweils ein Gehäuse eines Verlustwärme abgebenden Halbleiters bildet, also z.B. eines Thyristors, eines Chips oder eines besonders hoch belasteten Leistungstransistors.

Schließlich sei noch die nur scheinbar recht kompliziert aufgebaute besondere Variante 6 des Kühlkörpers erläutert, welche in der Fig. 1 in Seitenansicht und in der Fig. 8 in Draufsicht beispielhaft gezeigt ist. Bei dieser Variante 6 handelt es sich um ein bandförmiges Federelement mit mehreren Fiederzungen beidseitig längs der Bandkanten. Diese Fiederzungen der Variante 6 können z.B. aus einem Federblech 6 gemäß der Fig. 6 - eventuell mit unterschiedlichen Längen - gestanzt werden, und dabei oder später z.B. tulpenförmig gemäß den Fig. 1, 7 *) von Abwärmekörperecken aufweisen, vgl. die Fig.2,9.

(Seitenansichten) und 8 (Draufsicht) gebogen werden - jede Zunge entsprechend ihrer jeweiligen Länge -, und mit ihren Auflageflächen 3 in den Spalt unter Druckspannung eingefügt werden, vgl. die Fig. 1, 8. Jede Fiederzunge weist dann also eine eigene Auflagefläche 3 auf, welche sich wegen der hohen Biegeelastizität und Torsionselastizität der einzelnen Fiederzunge satt und trotzdem kräftig mit ihrer Auflagefläche 3 an die Abwärmekörper 1 (bzw. Körper 2) anlegen können. Die Bandmitte 3a, vgl. die Fig. 1, 6, kann dann zugleich als Auflageblech 3a dienen. Wenn solche Federelemente 6 verschieden lange Fiederzungen an jeder Bandkante aufweisen, vgl. die Fig. 6, dann können also, in einer Seitenansicht gemäß der Fig. 1 gesehen, mehr als zwei, also z.B. vier oder noch mehr, Reihen von fertig gebogenen Fiederzungen angebracht werden, wodurch die Kühlwirkung stärker ist als wenn nur zwei Reihen von Fiederzungen angebracht wären.

Die Auflageflächen 3 bzw. die Auflagebleche 3a müssen nicht stets vollständig am Abwärmekörper 1 bzw. an einem sonstigen Körper 2 unter Druckspannung anliegen, vgl. die Fig. 1. Manche Teile der Auflageflächen 3 können also auch frei schweben, z.B. seitlich über den Abwärmekörper 1 hinausragen. In manchen Fällen ist sogar beabsichtigt, einen bestimmten Abschnitt der Oberfläche, z.B. des Abwärmekörpers 1, schlecht zu kühlen und einen anderen Abschnitt gut zu kühlen, was z.B. auch durch eine entsprechende Verformung des hier sehr steifen, unschmiegsamen Auflagebleches 3a erreichbar ist, vgl. die Fig. 2, deren beide Kühlkörperbeispiele nur etwa mit der Hälfte ihrer Auflagebleche 3a auf den Abwärmekörpern 1 aufliegen.

13 Patentansprüche
10 Figuren

Patentansprüche.

1. Im Betrieb von einem Kühlmedium, z.B. Kühlluft, umströmter federnder Kühlkörper (4 bis 7) mit

- einer Auflagefläche (3) zur Bedeckung von Oberflächenteilen eines Abwärmekörpers (1), welcher zumindest zeitweise Verlustwärme abgibt, und

- einer oder mehreren wärmeleitenden - z.B. stabförmigen oder bandförmigen - im Betrieb vom Kühlmedium umspülten Kühlfahnen (4 bis 7),

d a d u r c h   g e k e n n z e i c h n e t ,   daß

- mindestens zwei Auflageflächen (3), welche weitgehend parallel einander gegenüber liegend im Spalt zwischen zwei Abwärmekörpern (1) unter Druckspannung einfügbar sind, angebracht sind, und

- zwischen diesen Auflageflächen (3) mindestens eine federnde gemeinsame Kühlfahne (4 bis 7) liegt, welche über die Auflageflächen (3) Federkräfte auf die Oberflächenteile dieser Abwärmekörper (1) ausübt, sobald der Kühlkörper (4 bis 7) zwischen diese Abwärmekörper (1) eingefügt ist.

2. Kühlkörper nach Patentanspruch 1,

d a d u r c h   g e k e n n z e i c h n e t ,   daß

- die Auflagefläche (3) jeweils durch eine Oberfläche eines Auflagebleches (3a) gebildet wird, und

- sich an den Auflageblechen (3a) die federnde(n) gemeinsame(n) Kühlfahne(n) (4 bis 7) abstützen.

3. Kühlkörper nach Patentanspruch 1 oder 2,

d a d u r c h   g e k e n n z e i c h n e t ,   daß

- die gemeinsame Kühlfahne (7) eine Spiralfeder bildet.

4. Kühlkörper nach Patentanspruch 2 und 3,
d a d u r c h   g e k e n n z e i c h n e t , daß
- in die Auflagebleche (3a) jeweils eine oder mehrere,
  für sich federnde Zungen (8) eingestanzt sind, und
- die in sich ebenfalls federnden Kühlfahnen (4 bis 7) sich
  jeweils an den Zungen (8) abstützen.

5. Kühlkörper nach Patentanspruch 1, 2 oder 3,
d a d u r c h   g e k e n n z e i c h n e t , daß
- die gemeinsame Kühlfahne (5) einen gefalteten Federblechstreifen bildet.

6. Kühlkörper nach Patentanspruch 2 und 5,
d a d u r c h   g e k e n n z e i c h n e t , daß
- der Federblechstreifen (5) und die Auflagebleche (3a)
  aus einem einzigen gefalteten Stück bestehen (Fig.4).

7. Kühlkörper nach Patentanspruch 1 oder 2,
d a d u r c h   g e k e n n z e i c h n e t , daß
- die gemeinsame Kühlfahne (4) eine elastische Filzstruktur aus sehr gut wärmeleitendem Material aufweist.

8. Kühlkörper nach Patentanspruch 7,
d a d u r c h   g e k e n n z e i c h n e t , daß
- er (4) auflageblechfreie Auflageflächen (3) aufweist.

9. Kühlkörper nach einem der vorhergehenden Patentansprüche,
d a d u r c h   g e k e n n z e i c h n e t , daß
- er vollständig aus Metall besteht.

10. Anwendung des Kühlkörpers nach einem der vorhergehenden Patentansprüche,
d a d u r c h   g e k e n n z e i c h n e t , daß
- er zwischen die Gehäuse zweier Abwärmekörper (1) unter
  Druckspannung eingefügt ist.

11. Anwendung des Kühlkörpers nach einem der vorhergehenden Patentansprüche,

d a d u r c h   g e k e n n z e i c h n e t ,   daß

- er (4a) zwischen einem Gehäuse eines Abwärmekörpers (1) und einem kaum oder nicht Verlustwärme abgebenden weiteren Körper (2) unter Druckspannung eingefügt ist.

12. Anwendung nach Patentanspruch 10 oder 11,

d a d u r c h   g e k e n n z e i c h n e t ,   daß

- seine Auflagefläche (3) verrutschfest    an den gedrückten Oberflächenteilen (1, 2) befestigt sind.

13. Anwendung nach Patentanspruch 10 oder 12,

d a d u r c h   g e k e n n z e i c h n e t ,   daß

- der Abwärmekörper (1) jeweils ein Gehäuse eines Verlustwärme abgebenden Halbleiterkörpers bildet.

# FIG 1

# FIG 2

# FIG 3

## FIG 4

## FIG 5

## FIG 6

## FIG 7

## FIG 8

FIG 9

FIG 10

Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| Y | DE-A-2 460 631 (SIEMENS) * Figuren 2a,3; Anspruch 1; Seite 4, Absatz 1 - Seite 5, Absatz 1; Seite 8, Absatz 3 * | 1 | H 01 L 23/46 H 01 L 23/42 |
| A | | 9,13 | |
| | --- | | |
| Y | US-A-3 993 123 (IBM) * Figur 8; Spalte 6, Zeilen 18-30 * | 1 | |
| A | | 3 | |
| | --- | | |
| A | DE-B-1 057 241 (SIEMENS) * Figuren 1,2 * | 5 | |
| | --- | | RECHERCHIERTE SACHGEBIETE (Int. Cl. 4) |
| A | IBM TECHNICAL DISCLOSURE BULLETIN, Band 20, Nr. 7, Dezember 1977, 2697-2698, New York, US; C.G. METREAUD: "Air-cooled semiconductor chip module configurations | 7 | H 01 L |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 02-12-1985 | DE RAEVE R.A.L. |